(19) Europäisches Patentamt
European Patent Office
Office européen des brevets

(11) **EP 4 768 936 A1**

(12) **EUROPEAN PATENT APPLICATION**
published in accordance with Art. 153(4) EPC

(43) Date of publication:
**01.07.2026 Bulletin 2026/27**

(21) Application number: **25774883.0**

(22) Date of filing: **04.03.2025**

(51) International Patent Classification (IPC):
*G01R 31/367* (2019.01)     *G01R 31/392* (2019.01)
*G01R 31/3842* (2019.01)     *G01R 19/165* (2006.01)
*H01M 10/42* (2006.01)

(52) Cooperative Patent Classification (CPC):
**G01R 19/165; G01R 31/367; G01R 31/3842;
G01R 31/392; H01M 10/42;** Y02E 60/10

(86) International application number:
**PCT/KR2025/002874**

(87) International publication number:
**WO 2025/198221 (25.09.2025 Gazette 2025/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.03.2024  KR 20240037908**

(71) Applicant: **LG Energy Solution, Ltd.
Seoul 07335 (KR)**

(72) Inventors:
• **JEON, Chul Min
  Daejeon 34122 (KR)**
• **KIM, Hong Keun
  Incheon 22212 (KR)**
• **BAEK, Ji Hoon
  Incheon 22212 (KR)**
• **LEE, Bom Jin
  Daejeon 34122 (KR)**
• **PARK, Sun Ho
  Daejeon 34122 (KR)**

(74) Representative: **Plasseraud IP
104 Rue de Richelieu
CS92104
75080 Paris Cedex 02 (FR)**

(54) **SIMULATION APPARATUS AND SIMULATION METHOD**

(57)     A simulation device according to an embodiment disclosed in this document includes a model generation unit configured to generate a shape model of a battery cell reflecting deformation of an electrode of the battery cell, a condition setting unit configured to set an electrolyte condition regarding whether an electrolyte is included in a deformed portion of the shape model of the battery cell and an operating condition of the battery cell, and a simulation unit configured to simulate a lithium precipitation state of the battery cell based on the shape model of the battery cell, the electrolyte condition, and the operating condition.

```
SIMULATION DEVICE
      100

MODEL GENERATION UNIT
      110

CONDITION SETTING UNIT
      120

SIMULATION UNIT
      130
```

FIG.1

## Description

## TECHNICAL FIELD

## CROSS-REFERENCE TO RELATED APPLICATIONS

This application claims priority from Korean Patent Application No. 10-2024-0037908, filed on March 19, 2024, the disclosure of which is incorporated by reference herein.

## TECHNICAL FIELD

Embodiments disclosed in this document relate to a simulation device and a simulation method.

## BACKGROUND ART

Recently, research and development on secondary batteries have been actively conducted. Here, secondary batteries are batteries that can be charged and discharged, and may be interpreted including both conventional Ni/Cd batteries, Ni/MH batteries, and recent lithium ion batteries. Recently, the scope of use of the lithium ion batteries has expanded to include a power source for electric vehicles, and the lithium ion batteries are attracting attention as a next-generation energy storage medium.

Electric vehicles receive electricity from the outside, charge battery cells/modules, and then discharge the battery cells/modules to drive the motor and obtain power. During the production and use stages, battery cells/modules undergo internal deformation and transformation through various charging and discharging, and their physical and chemical properties change. For example, deformation of a shape of the battery cell may cause lithium precipitation in the battery cell. Therefore, a technology is needed to diagnose and manage changes in physicochemical properties of battery cells due to battery degradation and deterioration.

## DISCLOSURE OF THE INVENTION

## TECHNICAL PROBLEM

Embodiments disclosed in this document provide a simulation device and a simulation method capable of simulating an effect of deformation of an electrode of a battery cell on lithium precipitation.

The technical objectives of the embodiments disclosed in this document are not limited to the technical problems mentioned above, and other technical problems not mentioned can be clearly understood by those skilled in the art from the descriptions below.

## TECHNICAL SOLUTION

A simulation device according to an embodiment disclosed in this document includes a model generation unit configured to generate a shape model of a battery cell reflecting deformation of an electrode of the battery cell, a condition setting unit configured to set an electrolyte condition regarding whether an electrolyte is included in a deformed portion of the shape model of the battery cell and an operating condition of the battery cell, and a simulation unit configured to simulate a lithium precipitation state of the battery cell based on the shape model of the battery cell, the electrolyte condition, and the operating condition.

According to an embodiment, the model generation unit may be configured to generate the shape model of the battery cell such that separation or delamination exists in a negative electrode or a positive electrode of the battery cell.

According to an embodiment, the deformation of the electrode of the battery cell may include at least one of delamination between the negative electrode and a negative electrode collector, delamination between the positive electrode and a positive electrode collector, separation between the negative electrode and a separator, and separation between the positive electrode and the separator.

According to an embodiment, the model generation unit may be configured to generate the shape model of the battery cell by changing a length of the separation or delamination.

According to an embodiment, the shape model of the battery cell may include a plurality of layers, and the plurality of layers may include a positive electrode collector layer, a positive electrode layer, a separator layer, a negative electrode layer, and a negative electrode collector layer.

According to an embodiment, the condition setting unit may be configured to apply a battery physical model, which is an electrochemical model of the battery cell, to the plurality of layers of the shape model of the battery cell, and set the electrolyte condition by changing a region to which the battery physical model is applied in the deformed portion.

According to an embodiment, the condition setting unit may be configured to set the operating condition by changing a charging start SOC, a charging end voltage, and a C-rate in a charging section of the battery cell.

According to an embodiment, the simulation unit may be configured to calculate a lithium precipitation potential, which is a difference between a solid phase potential and a liquid phase potential at both ends of the deformed portion in the operating condition, and simulate the lithium precipitation state of the battery cell based on the lithium precipitation potential.

According to an embodiment, the simulation unit may be configured to simulate a portion in the deformed portion in which the lithium precipitation potential is less than 0 as being in a lithium precipitation state.

A simulation method according to an embodiment disclosed in this document includes generating a shape model of a battery cell reflecting deformation of an electrode of the battery cell, setting an electrolyte condition regarding whether an electrolyte is included in a deformed portion of the shape model of the battery cell and an operating condition of the battery cell, and simulating a lithium precipitation state of the battery cell based on the shape model of the battery cell, the electrolyte condition, and the operating condition.

According to an embodiment, the generating of the shape model of the battery cell may include generating the shape model of the battery cell such that separation or delamination exists in a negative electrode or a positive electrode of the battery cell.

According to an embodiment, the deformation of the electrode of the battery cell may include at least one of the deformation of the electrode of the battery cell may include at least one of delamination between the negative electrode and a negative electrode collector, delamination between the positive electrode and a positive electrode collector, separation between the negative electrode and a separator, and separation between the positive electrode and the separator.

According to an embodiment, the simulation method may include generating the shape model of the battery cell by changing a length of the separation or delamination.

According to an embodiment, the shape model of the battery cell may include a plurality of layers, and the plurality of layers may include a positive electrode collector layer, a positive electrode layer, a separator layer, a negative electrode layer, and a negative electrode collector layer.

According to an embodiment, the setting of the electrolyte condition may include applying a battery physical model, which is an electrochemical model of the battery cell, to the plurality of layers of the shape model of the battery cell, and setting the electrolyte condition by changing a region to which the battery physical model is applied in the deformed portion.

According to an embodiment, the setting of the operating condition may include setting the operating condition by changing a charging start SOC, a charging end voltage, and a C-rate in a charging section of the battery cell.

According to an embodiment, the simulating of the lithium precipitation state of the battery cell may include calculating a lithium precipitation potential, which is a difference between a solid phase potential and a liquid phase potential at both ends of the deformed portion in the operating condition, and in the simulating of the lithium precipitation state of the battery cell, the lithium precipitation state of the battery cell may be simulated based on the lithium precipitation potential.

According to an embodiment, a portion in the deformed portion in which the lithium precipitation potential is less than 0 may be simulated as being in a lithium precipitation state.

## ADVANTAGEOUS EFFECTS

The simulation device and simulation method according to the embodiment disclosed in this document can simulate the effect of deformation of the electrode of the battery cell on lithium precipitation.

In addition, various effects may be provided that are directly or indirectly identified through this document.

## BRIEF DESCRIPTION OF THE DRAWINGS

FIG. 1 is a diagram showing a simulation device according to an embodiment disclosed in this document.

FIG. 2 is a diagram showing a shape model of a battery cell according to one embodiment disclosed in this document.

FIG. 3 is a diagram showing a shape model reflecting deformation of an electrode of a battery cell according to an embodiment disclosed in this document.

FIG. 4 is a diagram showing a shape model reflecting deformation of an electrode of a battery cell according to an embodiment disclosed in this document.

FIG. 5 is a diagram showing a shape model reflecting deformation of an electrode of a battery cell according to an embodiment disclosed in this document.

FIG. 6 is a diagram showing a simulation result according to an embodiment disclosed in this document.

FIG. 7 is a diagram showing a simulation result according to an embodiment disclosed in this document.

FIG. 8 is a flowchart showing an operating method of a simulation device according to an embodiment disclosed in this document.

FIG. 9 is a block diagram showing a hardware configuration of a computing system for performing an operating method of a simulation device according to an embodiment disclosed in this document.

## MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments of the present invention.

Various embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), or wirelessly or through a third component.

According to an embodiment, the method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

According to an embodiment, a battery cell is a basic unit of a battery cell that can be used by charging and discharging electric energy, and may be a lithium-ion (Li-ion) battery, a lithium-ion polymer (Li-ion polymer) battery, a nickel-cadmium (Ni-Cd) battery, a nickel-metal hydride (Ni-MH) battery, etc., but is not limited thereto.

According to the embodiment, the battery cell may include a plurality of stacked mono-cells. Here, the mono-cell may mean a unit cell including a pair of electrodes. For example, the battery cell may be configured as a jelly-roll in which mono-cells are stacked in a cylindrical shape, or may be configured as a pouch in which mono-cells are stacked in a stack.

According to the embodiment, the mono-cell may include a negative electrode, a negative electrode collector, a separator, a positive electrode, a positive electrode collector, and an electrolyte. Here, the negative electrode and the positive electrode may be made of a selected electrically conductive material and may be configured as a thin sheet or foil. The separator may separate the negative electrode and the positive electrode and provide a passage for lithium ions to move. The separator may include a separator made of an electrically insulating material such as a polymer or ceramic. The negative electrode collector and the positive electrode collector may provide electrical conductivity to the negative electrode and the positive electrode. The negative electrode collector may be formed of copper, and the positive electrode collector may be formed of aluminum. The electrolyte may mean a medium through which lithium ions move between the positive electrode and the negative electrode.

According to various embodiments, the shape of the battery cell may be deformed due to deterioration and degradation of the battery cell. Here, shape deformation of the battery cell may mean deformation of the electrode. For example, the deformation of the electrode may include separation or delamination of the electrode. Here, the separation may mean that a space (or gap) exists between the separator and the electrode (e.g., the positive electrode or the negative electrode), and the delamination may mean that a space (or gap) exists between a collector and the electrode (e.g., the positive electrode or the negative electrode). This shape deformation of the battery cell may change a movement path of electrons within the battery cell, and as a result, lithium precipitation may occur in the battery cell.

According to the embodiment, a degree of lithium precipitation may vary depending on a location the electrode where the deformation of the battery cell occurs and the degree of deformation thereof. Here, the deformation of the electrode of the battery cell may include at least one of the delamination between the negative electrode and the negative electrode collector, the delamination between the positive electrode and the positive electrode collector, the separation between the negative electrode and the separator, and the separation between the positive electrode and the separator. In addition, the degree of deformation may mean a length or area of the deformation between the electrode and the collector or between the electrode and the separator.

According to the embodiment, a degree of lithium precipitation may vary depending on whether the electrolyte is contained in a deformed portion of the electrode of the battery cell. Here, whether or not the electrolyte is contained may mean whether the electrolyte is contained in the separated or delaminated portion (e.g., the space or gap). Whether the deformed portion of the electrode of the battery cell is filled with an electrolyte may change the movement path of electrons and may affect the degree of lithium precipitation of the battery cell.

The simulation device 100 and simulation method described in this document can simulate the effect of the deformation of various electrodes described above on lithium precipitation. Through this, the simulation device 100 can derive a factor that can minimize lithium precipitation.

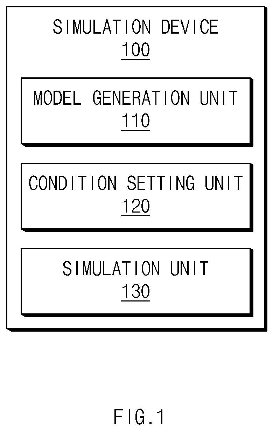

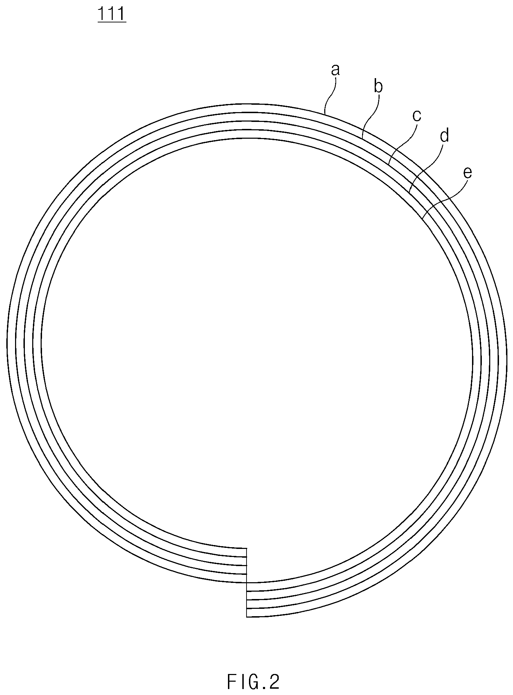

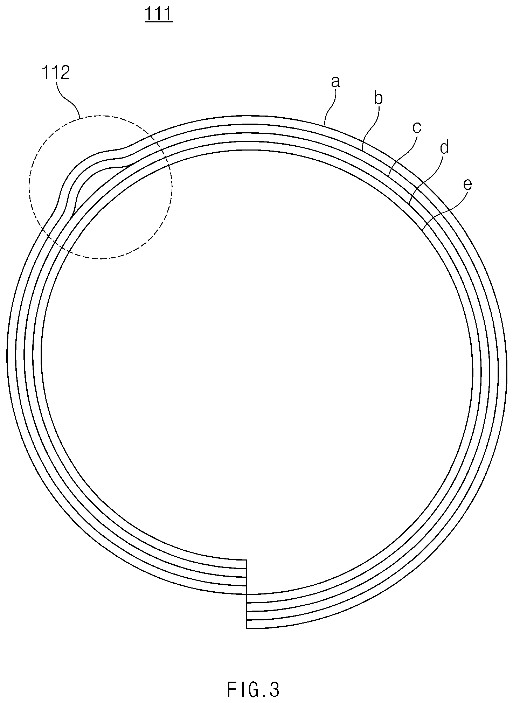

FIG. 1 is a diagram showing a simulation device according to an embodiment disclosed in this document. FIG. 2 is a diagram showing a shape model of a battery cell according to an embodiment disclosed in this document. FIGS. 3 to 5 are diagrams showing a shape model reflecting deformation of an electrode of a battery cell according to an embodiment disclosed in this document.

First, referring to FIGS. 1 and 2, the simulation device 100 may include a model generation unit 110, a condition setting unit 120, and a simulation unit 130.

According to an embodiment, the model generation unit 110 may generate a shape model 111 (see FIG. 2) of a battery cell. Here, a shape of the battery cell may include a mono-cell, a jelly-roll or stack cell in which mono-cells are stacked, etc.

The model generation unit 110 may generate the shape model 111 of the battery cell in a mono-cell shape. Here, the mono-cell may mean a unit cell including a pair of electrodes (e.g., a negative electrode and a positive electrode). For example, when the battery cell has a jelly roll shape, the model generation unit 110 may generate a shape model 111 of the mono-cell in a ring shape formed by a pair of electrodes. Here, the pair of electrodes may include a negative electrode and a positive electrode.

According to the embodiment, the model generation unit 110 may generate a shape model 111 of the battery cell including a plurality of layers a to e. Here, the plurality of layers a to e may include a negative electrode collector layer a, a negative electrode layer b, a separator layer c, a positive electrode layer d, and a positive electrode collector layer e. However, the present invention is not limited thereto, and some configurations may be omitted from the shape model 111 of the battery cell, and other general-purpose configurations may be further included in the shape model 111 of the battery cell.

According to the embodiment, the model generation unit 110 may generate the shape model 111 of the battery cell based on any computer aided design (CAD) program. For example, the model generation unit 110 may generate the shape model 111 of the battery cell based on a line tool of the CAD program.

According to the embodiment, the model generation unit 110 may generate the shape model 111 of the battery cell, which is a mono-cell including the negative electrode collector a, the negative electrode b, the separator c, the positive electrode d, and the positive electrode collector e, in a shape of single ring. Here, the model generation unit 110 may generate a mono-cell with a diameter of a predetermined length. For example, the model generation unit 110 may generate a mono-cell with a diameter of 4 to 5 mm. In FIG. 2, a case where the shape model 111 of the battery cell is a ring shape is exemplified, but is not limited thereto, and the model generation unit 110 may generate a shape model 111 of a battery cell of various shapes, including a linear shape, an elliptical shape, a parabolic shape, etc. Since the model generation unit 110 generates the shape model 111 of the battery cell in a mono-cell shape, the operation of the deformed battery cell may be quickly and accurately simulated using a pair of electrodes rather than stacked electrode layers of an actual jelly roll-shaped battery cell.

Referring to FIG. 3, the model generation unit 110 may generate a shape model 111 of a battery cell reflecting deformation 112 of the electrode of the battery cell. Here, the deformation 112 of the electrode of the battery cell may mean that a shape of a pair of mono-cells is deformed. For example, the deformation 112 of the electrode may include at least one of separation or delamination. Here, the separation may mean that a space (or gap) exists between the separator c and the electrode (e.g., the negative electrode c or the positive electrode d), and the delamination may mean that a space (or gap) exists between the collector a or e and the electrode (e.g., the negative electrode c or the positive electrode d).

According to the embodiment, the model generation unit 110 may generate the shape model 111 reflecting the deformation 112 of the electrode by offsetting each layer of a plurality of layers a to e in the shape model 111 of the battery cell. Therefore, the model generation unit 110 may change a degree of deformation 112 of the electrode of the battery cell by changing a degree of offset of each layer.

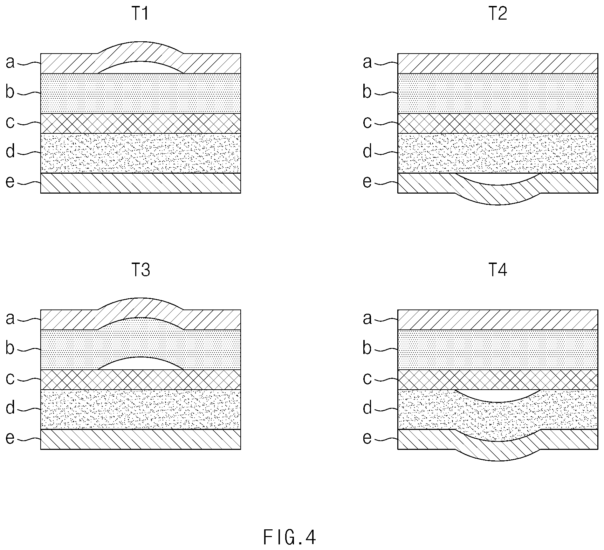

Referring to FIG. 4, the model generation unit 110 may determine a location where the separation or delamination exists in the battery cell. For example, the model generation unit 110 may generate a battery shape model 111 so that the separation of the battery cell exists in at least one of the negative electrode b and the positive electrode d of the mono-cell. In addition, the model generation unit 110 may generate the battery shape model 111 so that the delamination of the battery cell exists in at least one of the negative electrode b and the positive electrode d of the mono-cell. Through this, the model generation unit 110 may generate the shape model 111 of the battery cell reflecting various electrode deformation types.

According to the embodiment, the deformation of the electrode of the battery cell may include four types T1 to T4. For example, the deformation of the electrode of the battery cell may include at least one of separation T1 between the negative electrode b and the negative collector a, separation T2 between the positive electrode d and the positive collector e, separation T3 between the negative electrode b and the separator c, and separation T4 between the positive electrode d and the separator c.

According to the embodiment, the model generation unit 110 may change the degree of deformation of the electrode. For example, the model generation unit 110 may generate the shape model 111 of the battery cell by changing the degree of separation or delamination. According to the embodiment, the model generation unit 110 may generate the shape model 111 of the battery cell in which the electrode is deformed by changing a length or area of the separation or delamination. Here, the length of separation or delamination may mean a length of a space (or gap) between two layers in the shape model 111 when the shape model 111 of the battery cell is a two-dimensional model. In addition, the area of separation or delamination may mean an area of the space (or gap) between two layers in the shape model 111 when the shape model 111 of the battery cell is a three-dimensional model.

According to the embodiment, the model generation unit 110 may generate the shape model 111 of the battery cell with a minute degree of deformation or a serious degree of deformation based on the length of separation or delamination. Here, the minute delamination or separation may mean delamination or separation in which the length of the space (or gap) created by the delamination or separation is less than or equal to 25% of the length of the shape model 111 of the battery cell, and the severe delamination or separation may mean delamination or separation in which the length is greater than or equal to 60% of the length of the shape model 111 of the battery cell.

For example, when the shape model 111 of the battery cell is a single ring shape, the minute delamination or separation may mean that the length of the space (or gap) created by the delamination or separation is less than or equal to 25% of a diameter of a mono-cell. In contrast, the severe delamination or separation may mean that the length of the space (or gap) created by the delamination or separation is more than 60% of the diameter of the mono-cell. Therefore, the model generation unit 110 may generate the shape model 111 by changing the location at which the deformation of the electrode exists in the shape model 111 of the battery cell and/or the degree of deformation thereof, and thereby generate the shape model 111 that reflects various deformations of the electrode.

Referring back to FIG. 1, the condition setting unit 120 may set and manage various simulation conditions for simulating lithium precipitation of the battery cell using the shape model 111 of the battery cell. For example, the condition setting unit 120 may set various battery physical models that may be applied to the shape model 111 of the battery cell. Here, the battery physical model may be a model obtained by simulating an operation of an actual battery cell. Therefore, the battery physical model may include a model obtained by modeling an electrochemical phenomenon for the shape model 111 of the battery cell to operate like an actual battery cell. For example, the battery physical model may include one or more equations regarding an electrochemical reaction, a lithium (solid phase) diffusion phenomenon, a lithium ion (electrolyte) diffusion phenomenon, and an electric charge conservation phenomenon that occur in an electrode of a battery cell.

According to the embodiment, the condition setting unit 120 may set a simulation condition based on any program capable of simulating a physical phenomenon. For example, the condition setting unit 120 may set the simulation condition based on a COMSOL Multiphysics program. Here, the battery physical model may include a lithium-ion battery model, and the battery physical model may calculate the ion transport and potential gradient in the electrolyte in a region where the battery physical model is applied.

According to the embodiment, the condition setting unit 120 may apply the battery physical model to each of the plurality of layers of the shape model 111 of the battery cell. For example, the condition setting unit 120 may apply the battery physical model described above to the negative electrode collector layer a, the negative electrode layer b, the separator layer c, the positive electrode layer d, and the positive electrode collector layer e. Through this, the condition setting unit 120 may set the shape model 111 of the battery cell to operate like a battery cell.

According to the embodiment, the condition setting unit 120 may set a boundary condition in the shape model 111 of the battery cell. Here, the boundary condition may mean an electrical condition for the battery cell to operate. For example, the condition setting unit 120 may set the boundary condition so that a ground voltage (e.g., 0 [V]) is applied to the negative electrode layer b and a predetermined current is applied to the positive electrode layer d. In addition, the condition setting unit 120 may set the boundary condition so that the remaining layers except for the negative electrode layer b and the positive electrode layer d have an insulating boundary.

According to the embodiment, the condition setting unit 120 may set an operating condition of the battery cell. Here, the operation of the battery cell may mean a charging/discharging operation. Therefore, the condition setting unit 120 may set operating condition such as a voltage, a current applied to the battery cell, or a C-rate thereof in a charging section, a discharging section, or a resting section of the battery cell. In addition, the operating condition may mean a condition regarding a state of the battery cell in the charging/discharging operation. For example, the condition setting unit 120 may include an operating condition regarding the state of the battery cell such as SOC, SOH, cycle, or temperature. Therefore, the condition setting unit 120 may provide various operating environments by setting the condition under which the battery cell operates.

According to the embodiment, the condition setting unit 120 may set the operating condition by changing the charging start SOC, the charging end voltage, and the C-rate in the charging section of the battery cell. Here, the charging start SOC may mean the SOC of the battery cell at the point in time when charging starts, the charging end voltage may mean the battery voltage of the battery cell at which charging of the battery cell ends, and the C-rate may mean the speed of charging. For example, the condition setting unit 120 may set the operating condition of the battery cell so that the battery cell with an SOC of 10% is charged at a C-rate of 1C until the voltage of the battery cell becomes 4.2 V.

According to the embodiment, the condition setting unit 120 may set the same operating condition for various shape models 111 of battery cells accompanied by deformation of the electrode. Through this, the condition setting unit 120 may ensure that the effect of deformation of the battery cell electrode on lithium precipitation is simulated in the same operating environment.

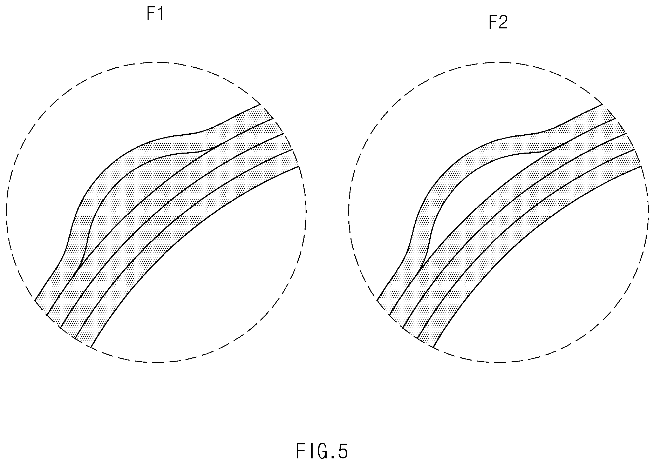

Referring to FIG. 5, the condition setting unit 120 may set an electrolyte condition regarding whether or not the deformed portion contains an electrolyte in the shape model 111 of the battery cell. As described above, whether the electrolyte is contained in the deformed portion may mean whether the separated or delaminated portion contains the electrolyte. According to an embodiment, the electrolyte condition may include a case where the space (or gap) between the two layers is filled with the electrolyte or a case where the space (or gap) is an empty space (e.g., a void). Through this, the condition setting unit 120 may simulate the movement path of electrons according to whether the deformed portion of the electrode of the battery cell contains the electrolyte. In addition, the intensity and region of lithium precipitation may be simulated according to whether the deformed portion of the electrode of the battery cell is filled with the electrolyte or is a void.

According to the embodiment, the condition setting unit 120 may set the electrolyte condition by changing a region to which a battery physical model is applied in the deformed portion of the shape model 111 of the battery cell. For example, the condition setting unit 120 may apply the battery physical model to the space (or gap) between the two separated or delaminated layers when the deformed portion of the electrode contains an electrolyte (F1). In contrast, the condition setting unit 120 may not apply the battery physical model to the space (or gap) between the two separated or delaminated layers when the deformed portion of the electrode does not contain an electrolyte (F2). Therefore, when the condition setting unit 120 applies the battery physics model to the deformed portion, the physical model may calculate the ion transport and potential gradient in the electrolyte in the deformed portion.

Referring back to FIG. 1, the simulation unit 130 may perform a simulation by applying the set condition to the shape model 111 of the battery cell. The simulation unit 130 may perform the simulation based on any program that may simulate a physical phenomenon. For example, the simulation unit 130 may perform a simulation based on the same program as in the condition setting unit 120.

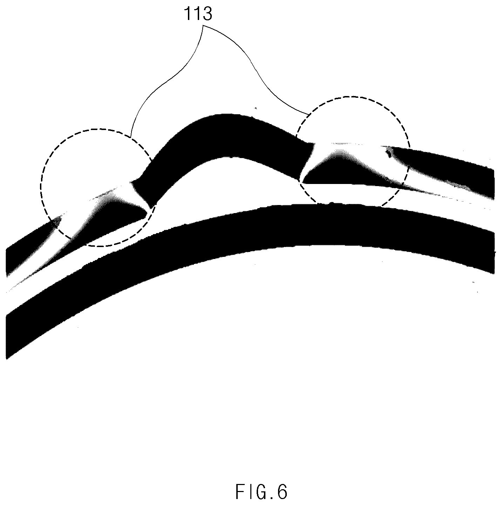

According to the embodiment, the simulation unit 130 may simulate a lithium precipitation state of the battery cell based on the shape model 111, electrolyte condition, and operating condition of the battery cell. For example, the simulation unit 130 may simulate the lithium precipitation state by calculating a lithium precipitation potential at both ends of the deformed portion of the battery cell under the electrolyte condition and operating condition. Here, both ends of the deformed portion may be described with reference to FIG. 6.

FIGS. 6 to 7 are diagram showing simulation results according to an embodiment disclosed in this document.

First, referring to FIG. 6, the simulation unit 130 may simulate the lithium precipitation state by calculating the lithium precipitation potential at both ends 113 of the deformed portion of the battery cell. Here, the both ends 113 of the deformed portion may mean portions adjacent to the start and end points of a portion where the deformation exists. According to the embodiment, the both ends 113 of the deformed portion may include portions of the electrode adjacent to the both ends of the deformed portion.

According to the embodiment, the simulation unit 130 may calculate the lithium precipitation potential based on a difference between solid-phase potential and liquid-phase potential at the both ends 113 of the deformed portion. Here, the solid-phase potential may mean the potential of a solid-phase active material matrix (a positive electrode or a negative electrode) within the electrode and the liquid-phase potential may mean the potential of electrolyte solution impregnated in an electrode pore layer. According to the embodiment, the simulation unit 130 may calculate the solid-phase potential and the liquid-phase potential based on the charge conservation in the solid-phase active material of the electrode (positive electrode or negative electrode), the charge conservation in the electrolyte, the lithium concentration in active material particles, the lithium ion concentration distribution in the electrolyte, and the electrochemical reaction formula of the battery physical model.

According to the embodiment, the simulation unit 130 may calculate the lithium precipitation potential using <Equation 1> below.

<Equation 1>

$$\eta_{Li} = \Phi_s - \Phi_l$$

Here, $\eta_{Li}$ may mean lithium precipitation potential (unit: V), $\Phi_s$ may mean solid-phase potential of the electrodes located at the both ends 113 of the deformed portion, and $\Phi_l$ may mean liquid-phase potential.

According to the embodiment, the simulation unit 130 may simulate a portion where the lithium precipitation potential at the both ends 113 of the deformed portion is less than 0 as being in a lithium precipitation state. For example, the simulation unit 130 may simulate that the more the absolute value of the calculated lithium precipitation potential becomes a larger negative number, the more lithium is in a state of being precipitated.

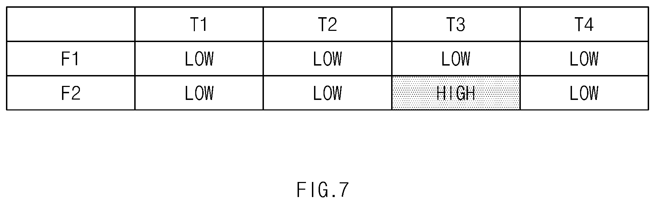

Referring to FIG. 7, the simulation unit 130 may calculate the results of the simulation as shown in FIG. 7 and provide the results to a user. For example, the simulation unit 130 may calculate the degree of lithium precipitation (or the possibility of lithium precipitation) derived according to types of separation or delamination T1 to T4 and electrolyte conditions F1 and F2.

According to the embodiment, the simulation unit 130 may calculate the degree of lithium precipitation (or the possibility of lithium precipitation) based on the lithium precipitation potential of <Equation 1> described above. For example, the simulation unit 130 may calculate the degree of lithium precipitation (or the possibility of lithium precipitation) as low when the lithium precipitation potential is between $-10^{-3}$ and 0. In addition, the simulation unit 130 may calculate the degree of lithium precipitation as high when the lithium precipitation potential is less than $-10^{-1}$. According to the embodiment, when the lithium precipitation potential of the deformed battery cell is 100 times or more than the lithium precipitation potential calculated by simulating a normal battery cell without deformation, the simulation unit 130 may determine that the degree of lithium precipitation of the deformed battery cell is high.

According to the embodiment, the types of separation or delamination T1 to T4 may include delamination T1 between the negative electrode b and the negative electrode collector a, delamination T2 between the positive electrode d and the positive electrode collector e, separation T3 between the negative electrode b and the separator c, and separation T4 between the positive electrode d and the separator c. In addition, the electrolyte conditions F1 and F2 may include the case where the deformed portion of the electrode includes the electrolyte (F1) and the case where the deformed portion of the electrode does not include the electrolyte (F2).

According to the simulation results performed by the simulation device 100 and simulation method disclosed in this document, the possibility of lithium precipitation was the highest when the separation T3 between the negative electrode b and the separator c exists and the separation T3 portion does not include the electrolyte (F2). According to the embodiment, when the separation T3 of the negative electrode b exists, lithium ions may move bypassing the separation portion during charging of the battery cell and the lithium ion concentration at both ends of the separated portion may increase. Therefore, as the concentration gradient of lithium ions increases, the liquid phase potential $\Phi_l$ at both ends of the separation portion may increase. In addition, as the liquid phase potential $\Phi_l$ increases, the value of the lithium precipitation potential $\eta_{Li}$ becomes more negative, and accordingly, more lithium may be reduced and over-precipitation of lithium may occur.

According to the simulation results performed by the simulation device 100 and simulation method disclosed in this document, severe delamination may increase the possibility of lithium precipitation compared to minute delamination. For example, in the case of severe delamination where the delamination length is long or the delamination area is wide, an actual usable area of the electrode may decrease and the C-rate may increase in the operation of the battery cell. Therefore, severe delamination compared to minute delamination may increase the possibility of lithium precipitation from the negative electrode or positive electrode.

According to the simulation results performed by the simulation device 100 and simulation method disclosed in this document, when the separation T3 between the negative electrode b and the separator c is a severe separation and the separation portion does not include the electrolyte (F2), it was found that the possibility of lithium precipitation is higher than in the case of minute separation. In contrast, the separation T4 between the positive electrode d and the separator c was found to have a low possibility of lithium precipitation regardless of whether it was the minute separation or the severe separation. For example, since the separation T4 between the positive electrode d and the separator c is not related to the usable area of the negative electrode but only reduces the usable area of the positive electrode in the operation of the battery cell, it was found that the possibility of lithium precipitation is low.

Therefore, based on the simulation results performed by the simulation device 100 and simulation method disclosed in this document, the result that the possibility of lithium precipitation due to deformation of the electrode is minimized may be derived when the separation T3 between the negative electrode b and the separator c is reduced may be derived. Therefore, the user may establish a use and/or management plan of the battery cell for minimizing lithium precipitation based on the simulation device 100 and simulation method. For example, the user can minimize the possibility of lithium precipitation of the battery cell by improving the performance of a binder, which is the interface between the negative electrode b and the separator c, based on the simulation results.

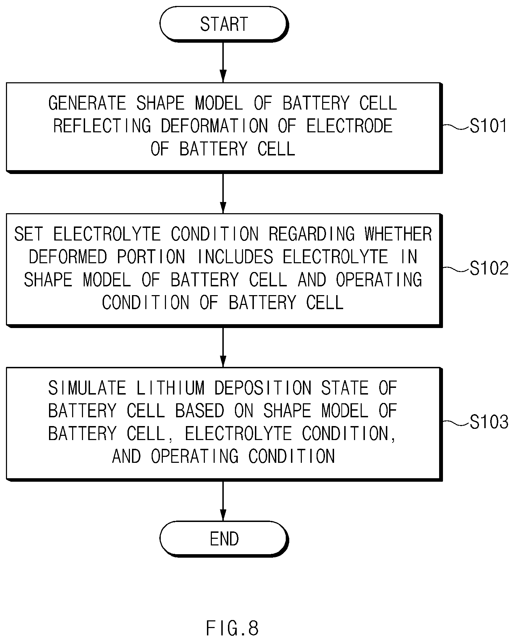

FIG. 8 is a flowchart showing an operating method of a simulation device according to an embodiment disclosed in this document.

Referring to FIG. 8, the simulation device 100 may generate a shape model of a battery cell reflecting deformation of an electrode of a battery cell (S101), set an electrolyte condition regarding whether a deformed portion includes an electrolyte in the shape model of the battery cell and an operating condition of the battery cell (S102), and simulate a lithium deposition state of the battery cell based on the shape model of the battery cell, the electrolyte condition, and the operating condition (S103).

In step S101, the simulation device 100 may generate a shape model 111 of the battery cell reflecting the deformation of the electrode of the battery cell (S101).

In step S102, the simulation device 100 may set the electrolyte condition regarding whether the deformed portion contains an electrolyte in the shape model 111 of the battery cell and the operating condition of the battery cell (S102).

In step S103, the simulation device 100 may simulate a lithium precipitation state of the battery cell based on the shape model 111, the electrolyte condition, and the operating condition of the battery cell (S103).

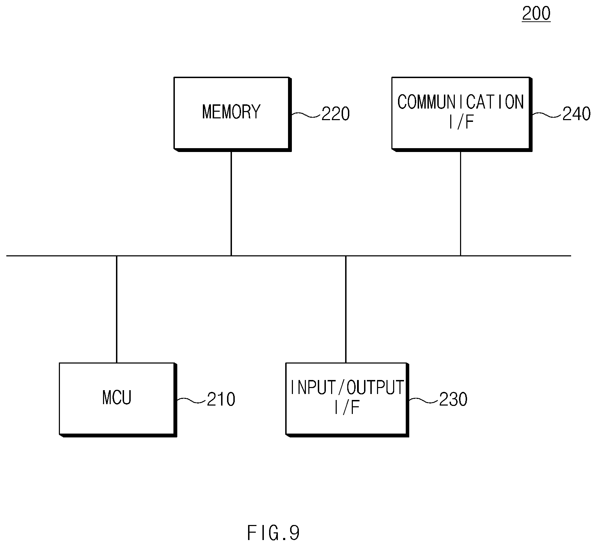

FIG. 9 is a block diagram showing a hardware configuration of a computing system for performing an operating method of a simulation device according to an embodiment disclosed in this document.

Referring to FIG. 9, a computing system 200 according to an embodiment disclosed in this document may include an MCU 210, a memory 220, an input/output I/F 230, and a communication I/F 240.

The MCU 210 may be a processor that executes various programs (e.g., design and technical document writing program, drafting program (e.g., Auto CAD), design analysis program, physical phenomenon analysis program (e.g., COMSOL Multiphysics), modeling program, etc.) stored in the memory 220, processes various information including characteristic data, latent variables, etc. of the battery cell through these programs, and performs the functions of the simulation device 100 shown in FIGS. 1 to 8 described above.

The memory 220 may store various programs such as the design and technical document writing program, the drafting program (e.g., Auto CAD), the design analysis program, the physical phenomenon analysis program (e.g., COMSOL Multiphysics), the modeling program, etc.

A plurality of such memories 220 may be provided as needed. The memory 220 may be a volatile memory or a nonvolatile memory. The memory 220 as the volatile memory may be RAM, DRAM, SRAM, or the like. The memory 220 as the nonvolatile memory may be ROM, PROM, EAROM, EPROM, EEPROM, flash memory, etc. The examples of the memories 220 listed above are only examples and are not limited to these examples.

The input/output I/F 230 may provide an interface that allows data to be transmitted and received between an input device (not shown) such as a keyboard, mouse, or touch panel, and an output device (not shown) such as a display and the MCU 210.

The communication I/F 240 is a configuration that can transmit and receive various data with the server, and may be various devices that can support wired or wireless communication. For example, the simulation device 100 may transmit and receive various information, including a shape model of a battery cell, from a separately provided external server through the communication I/F 240.

In this way, the computer program according to an embodiment disclosed in this document may be implemented as a module that performs, for example, each function shown in FIG. 1, by being recorded in the memory 220 and processed by the MCU 210.

In the above, even though all the components constituting the embodiments disclosed in this document have been described as being combined as one or operating in combination, the embodiments disclosed in this document are not necessarily limited to these embodiments. That is, within the scope of the purpose of the embodiments disclosed in this document, all of the components may be selectively combined and operated in combination as one or more.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The disclosure described above outlines features of several embodiments so that those skilled in the art may better understand the aspects of the present disclosure. Those skilled in the art will understand that the present disclosure may easily be used as a basis for designing or modifying other structures to perform the same purposes or achieve the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

**Claims**

1. A simulation device comprising:

a model generation unit configured to generate a shape model of a battery cell reflecting deformation of an electrode of the battery cell;

a condition setting unit configured to set an electrolyte condition regarding whether an electrolyte is included in a deformed portion of the shape model of the battery cell and an operating condition of the battery cell; and

a simulation unit configured to simulate a lithium precipitation state of the battery cell based on the shape model of the battery cell, the electrolyte condition, and the operating condition.

2. The simulation device of claim 1, wherein the model generation unit is configured to generate the shape model of the battery cell such that separation or delamination exists in a negative electrode or a positive electrode of the battery cell.

3. The simulation device of claim 2, wherein the deformation of the electrode of the battery cell includes at least one of delamination between the negative electrode and a negative electrode collector, delamination between the positive electrode and a positive electrode collector, separation between the negative electrode and a separator, and separation between the positive electrode and the separator.

4. The simulation device of claim 2, wherein the model generation unit is configured to generate the shape model of the battery cell by changing a length of the separation or delamination.

5. The simulation device of claim 1, wherein the shape model of the battery cell includes a plurality of layers, and the plurality of layers include a positive electrode collector layer, a positive electrode layer, a separator layer, a negative electrode layer, and a negative electrode collector layer.

6. The simulation device of claim 5, wherein the condition setting unit is configured to apply a battery physical model, which is an electrochemical model of the battery cell, to the plurality of layers of the shape model of the battery cell, and set the electrolyte condition by changing a region to which the battery physical model is applied in the deformed portion.

7. The simulation device of claim 1, wherein the condition setting unit is configured to set the operating condition by changing a charging start SOC, a charging end voltage, and a C-rate in a charging section of the battery cell.

8. The simulation device of claim 1, wherein the simulation unit is configured to calculate a lithium precipitation potential, which is a difference between a solid phase potential and a liquid phase potential at both ends of the deformed portion in the operating condition, and

simulate the lithium precipitation state of the battery cell based on the lithium precipitation potential.

9. The simulation device of claim 8, wherein the simulation unit is configured to simulate a portion in the deformed portion in which the lithium precipitation potential is less than 0 as being in a lithium precipitation state.

10. A simulation method comprising:

generating a shape model of a battery cell reflecting deformation of an electrode of the battery cell;

setting an electrolyte condition regarding whether an electrolyte is included in a deformed portion of the shape model of the battery cell and an operating condition of the battery cell; and

simulating a lithium precipitation state of the battery cell based on the shape model of the battery cell, the electrolyte condition, and the operating condition.

11. The simulation method of claim 10, wherein the generating of the shape model of the battery cell includes generating the shape model of the battery cell such that separation or delamination exists in a negative electrode or a positive electrode of the battery cell.

12. The simulation method of claim 11, wherein the deformation of the electrode of the battery cell includes at least one of delamination between the negative electrode and a negative electrode collector, delamination between the positive electrode and a positive electrode collector, separation between the negative electrode and a separator, and separation between the positive electrode and the separator.

13. The simulation method of claim 11, further comprising:

generating the shape model of the battery cell by changing a length of the separation or delamination.

14. The simulation method of claim 10, wherein the shape model of the battery cell includes a plurality of layers, and the plurality of layers includes a positive electrode collector layer, a positive electrode layer, a separator layer, a negative electrode layer, and a negative electrode collector layer.

15. The simulation method of claim 14, wherein the setting of the electrolyte condition includes applying a battery physical model, which is an electrochemical model of the battery cell, to the plurality of layers of the shape model of the battery cell, and setting the electrolyte condition by changing a region to which the battery physical model is applied in the deformed portion.

16. The simulation method of claim 10, wherein the setting of the operating condition includes setting the operating condition by changing a charging start SOC, a charging end voltage, and a C-rate in a charging section of the battery cell.

17. The simulation method of claim 10, wherein the simulating of the lithium precipitation state of the battery cell includes calculating a lithium precipitation potential, which is a difference between a solid phase potential and a liquid phase potential at both ends of the deformed portion in the operating condition, and
in the simulating of the lithium precipitation state of the battery cell, the lithium precipitation state of the battery cell is simulated based on the lithium precipitation potential.

18. The simulation method of claim 17, wherein a portion in the deformed portion in which the lithium precipitation potential is less than 0 is simulated as being in a lithium precipitation state.

SIMULATION DEVICE
100

MODEL GENERATION UNIT
110

CONDITION SETTING UNIT
120

SIMULATION UNIT
130

FIG.1

111

FIG.2

FIG.3

T1

a
b
c
d
e

T2

a
b
c
d
e

T3

a
b
c
d
e

T4

a
b
c
d
e

FIG.4

F1

F2

FIG.5

FIG.6

|  | T1 | T2 | T3 | T4 |
|---|---|---|---|---|
| F1 | LOW | LOW | LOW | LOW |
| F2 | LOW | LOW | HIGH | LOW |

FIG.7

START

GENERATE SHAPE MODEL OF BATTERY CELL REFLECTING DEFORMATION OF ELECTRODE OF BATTERY CELL — S101

SET ELECTROLYTE CONDITION REGARDING WHETHER DEFORMED PORTION INCLUDES ELECTROLYTE IN SHAPE MODEL OF BATTERY CELL AND OPERATING CONDITION OF BATTERY CELL — S102

SIMULATE LITHIUM DEPOSITION STATE OF BATTERY CELL BASED ON SHAPE MODEL OF BATTERY CELL, ELECTROLYTE CONDITION, AND OPERATING CONDITION — S103

END

FIG.8

200

MEMORY ~220

COMMUNICATION I/F ~240

MCU ~210

INPUT/OUTPUT I/F ~230

FIG.9

## INTERNATIONAL SEARCH REPORT

| International application No. |
| --- |
| **PCT/KR2025/002874** |

| A. | CLASSIFICATION OF SUBJECT MATTER |
| --- | --- |

**G01R 31/367**(2019.01)i; **G01R 31/392**(2019.01)i; **G01R 31/3842**(2019.01)i; **G01R 19/165**(2006.01)i; **H01M 10/42**(2006.01)i

According to International Patent Classification (IPC) or to both national classification and IPC

| B. | FIELDS SEARCHED |
| --- | --- |

Minimum documentation searched (classification system followed by classification symbols)

G01R 31/367(2019.01); G01R 31/36(2006.01); G06F 119/08(2020.01); G06F 30/23(2020.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 형상 모델(shape model), 전해질(electrolyte), 시뮬레이션 (simulation), 리튬 석출(lithium precipitation)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2022-0092058 A (INDUSTRY-ACADEMIC COOPERATION FOUNDATION, YONSEI UNIVERSITY) 01 July 2022 (2022-07-01) See paragraphs [0017] and [0096]; claims 1-2; and figure 1. | 1-18 |
| A | KR 10-2022-0038789 A (TWAICE TECHNOLOGIES GMBH) 29 March 2022 (2022-03-29) See paragraph [0043]; claim 1; and figure 8. | 1-18 |
| A | KR 10-2018-0087041 A (LG CHEM, LTD.) 01 August 2018 (2018-08-01) See paragraphs [0033]-[0035]; and figure 3. | 1-18 |
| A | KR 10-2021-0074003 A (LG ENERGY SOLUTION, LTD.) 21 June 2021 (2021-06-21) See paragraphs [0169]-[0189]; and figure 11. | 1-18 |

| ☑ Further documents are listed in the continuation of Box C. | ☑ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **30 May 2025** | **01 June 2025** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| | International application No. |
|---|---|
| | **PCT/KR2025/002874** |

### C. DOCUMENTS CONSIDERED TO BE RELEVANT

| Category* | Citation of document, with indication, where appropriate, of the relevant passages | Relevant to claim No. |
|---|---|---|
| A | 김병묵. 리튬이온전지의 비가역적 리튬손실과 리튬 석출에 따른 방전 거동모델링. 공학 석사학위 논문. August 2022, pp. 1-54 (KIM, Byungmook. Modeling the effect of cyclable lithium loss and lithium plating on the discharge behaviors of a lithium-ion battery. Master of Engineering Thesis). [Retrieved on 15 May 2025]. Retrieved from <https://dspace.ajou.ac.kr/handle/2018.oak/20884>. See pages 1-48. | 1-18 |

Form PCT/ISA/210 (second sheet) (July 2022)

**INTERNATIONAL SEARCH REPORT**
Information on patent family members

International application No.

**PCT/KR2025/002874**

| Patent document cited in search report | | | Publication date (day/month/year) | Patent family member(s) | | | Publication date (day/month/year) |
|---|---|---|---|---|---|---|---|
| KR | 10-2022-0092058 | A | 01 July 2022 | KR | 10-2540721 | B1 | 05 June 2023 |
| KR | 10-2022-0038789 | A | 29 March 2022 | CN | 114245898 | A | 25 March 2022 |
| | | | | DE | 102019121461 | B3 | 24 December 2020 |
| | | | | EP | 4010837 | A1 | 15 June 2022 |
| | | | | JP | 2022-543322 | A | 11 October 2022 |
| | | | | JP | 7255020 | B2 | 10 April 2023 |
| | | | | KR | 10-2708340 | B1 | 23 September 2024 |
| | | | | US | 2022-0374568 | A1 | 24 November 2022 |
| | | | | WO | 2021-023346 | A1 | 11 February 2021 |
| KR | 10-2018-0087041 | A | 01 August 2018 | CN | 109565085 | A | 02 April 2019 |
| | | | | CN | 109565085 | B | 03 June 2022 |
| | | | | CN | 208157567 | U | 27 November 2018 |
| | | | | EP | 3483978 | A2 | 15 May 2019 |
| | | | | EP | 3483978 | B1 | 29 March 2023 |
| | | | | ES | 2943086 | T3 | 08 June 2023 |
| | | | | HU | E061513 | T2 | 28 July 2023 |
| | | | | JP | 2019-522881 | A | 15 August 2019 |
| | | | | JP | 6751466 | B2 | 02 September 2020 |
| | | | | KR | 10-2192676 | B1 | 17 December 2020 |
| | | | | PL | 3483978 | T3 | 29 May 2023 |
| | | | | US | 11561152 | B2 | 24 January 2023 |
| | | | | US | 2020-0158596 | A1 | 21 May 2020 |
| | | | | WO | 2018-139834 | A2 | 02 August 2018 |
| | | | | WO | 2018-139834 | A3 | 04 October 2018 |
| KR | 10-2021-0074003 | A | 21 June 2021 | CN | 114207456 | A | 18 March 2022 |
| | | | | CN | 114207456 | B | 12 April 2024 |
| | | | | EP | 3989330 | A1 | 27 April 2022 |
| | | | | EP | 3989330 | B1 | 20 September 2023 |
| | | | | ES | 2960033 | T3 | 29 February 2024 |
| | | | | HU | E062992 | T2 | 28 December 2023 |
| | | | | JP | 2022-536310 | A | 15 August 2022 |
| | | | | JP | 7293566 | B2 | 20 June 2023 |
| | | | | PL | 3989330 | T3 | 22 January 2024 |
| | | | | US | 11821960 | B2 | 21 November 2023 |
| | | | | US | 2022-0373607 | A1 | 24 November 2022 |
| | | | | WO | 2021-118118 | A1 | 17 June 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240037908